**Europäisches Patentamt**

**European Patent Office**

**Office européen des brevets**

(19)

(11) Publication number : **0 272 938 B1**

# EUROPEAN PATENT SPECIFICATION

(12)

(45) Date of publication of patent specification :
**30.11.94 Bulletin 94/48**

(51) Int. Cl.⁵ : **H03L 7/18**

(21) Application number : **87311404.5**

(22) Date of filing : **23.12.87**

(54) **Frequency synthesizer.**

(30) Priority : **23.12.86 JP 305253/86**
**22.05.87 JP 123731/87**

(43) Date of publication of application :
**29.06.88 Bulletin 88/26**

(45) Publication of the grant of the patent :
**30.11.94 Bulletin 94/48**

(84) Designated Contracting States :
**DE FR GB SE**

(56) References cited :
**EP-A- 0 186 854**
**EP-A- 0 211 594**
**FR-A- 2 128 056**
**US-A- 3 813 610**
**US-A- 4 034 310**
**SOVIET INVENTIONS ILLUSTRATED , Week**
**B18, June 14, 1979m ref, no D9534; Derwent**
**Publ. Ltd, London, GB & SU-A-611 286**
**PATENT ABSTRACTS OF JAPAN, vol 8, no.**
**181 (E-261)(1618), August 21, 1984 & JP-A-59**
**74 734**
**REVIEW OF THE ELECTRICAL COMMUNI-**
**CATION LABORATORIES, vol. 30, no. 2, March**
**1982, pages 346-358; Tokyo, JP; Y.AKAZAWA**
**et al.: "Frequency synthesizer LSI for new**
**mobile radio unit"**

(56) References cited :
**TELECOMMUNICATIONS & RADIO EN-**
**GINEERING, vol. 37/38, no. 10, October 1983,**
**pages 13-19;Scripta Publ. Co.,Silver Spring,**
**US; V.V.SHAKHGIL'DYAN et al.: "General**
**principles for designing fast frequency synth-**
**esizers based on phase sync systems"**
**PATENT ABSTRACTS OF JAPAN, vol. 7, no.**
**132 (E-180)(1277), June 9, 1983; & JP-**
**A-5848538**

(73) Proprietor : **NIPPON TELEGRAPH AND**
**TELEPHONE CORPORATION**
**1-6 Uchisaiwaicho 1-chome**
**Chiyoda-ku**
**Tokyo (JP)**

(72) Inventor : **Saito, Shigeki**
**1-28, Deiki**
**Kanazawa-ku**
**Yokohama-shi Kanagawa (JP)**
Inventor : **Suzuki, Hiroshi**
**2-28-209, Maborikaigan**
**Yokosuka-shi Kanagawa (JP)**
Inventor : **Tarusawa, Yoshiaki**
**9-2-12, Sugita**
**Isogo-ku**
**Yokohama-shi Kanagawa (JP)**

(74) Representative : **Pike, Harold John et al**
**Abel & Imray**
**Northumberland House**
**303-306 High Holborn**
**London, WC1V 7LH (GB)**

EP 0 272 938 B1

## Description

(Technical Field)

This invention relates to a frequency synthesizer used in mobile radio communications, satellite communications, terrestrial microwave communications, and other radio equipments. More particularly, this invention relates to a frequency synthesizer which operates intermittently to reduce power consumption and which locks phases at a high speed in switching from OFF to ON. This invention further relates to a programmable frequency divider used in frequency synthesizer and more particularly to a programmable frequency divider for which internal conditions can be preset.

(Prior Art)

The reduced power consumption is a critical factor in portable telephone sets and other mobile radio transmitter/receivers. The reduction of power consumption for frequency synthesizers is particularly an important challenge. For this purpose, power consumption should be reduced not only by optimizing the circuit structure but also by optimizing circuit operations such as intermittent operation.

The prior art intermittently controlled frequency synthesizer, however, is detrimental in that it entails fluctuation in frequency when it intermitenttly switches the power supply ON/OFF.

There have been proposed various circuits to suppress such fluctuations. But these prior art circuits are not quite satisfactory as they are not effective in intermittent control of phase lock such as intermittent PLL operation (which will be described hereinafter) for obtaining stable signals constantly although they are effective in suppressing the frequency fluctuation at a low level.

The details of prior art are now described.

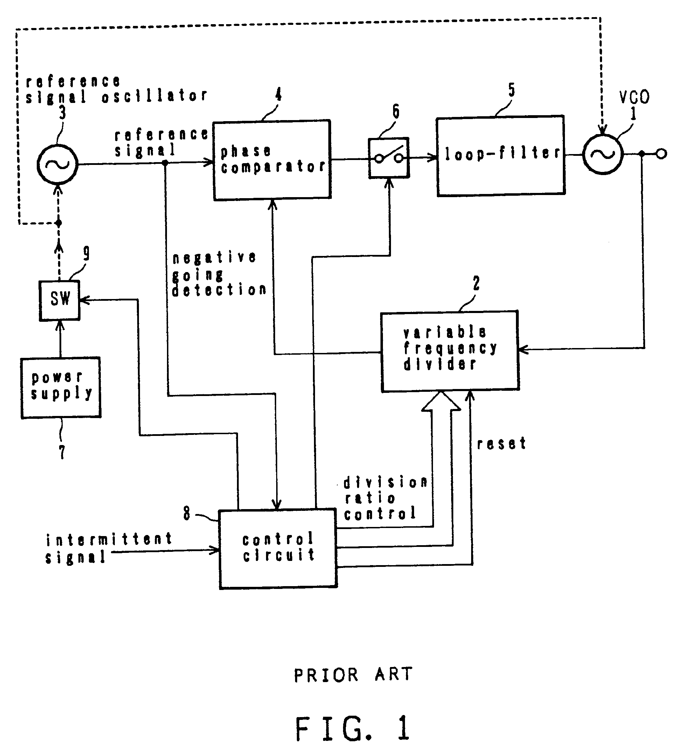

FIG. 1 is a block diagram to show a basic structure of a prior art frequency synthesizer which operates intermittently.

As shown in the figure. the output from a voltage controlled oscillator 1 (abbreviated as VCO in the figure) is divided in frequency by variable frequency divider 2, the phase of the output signals therefrom is compared with the phase of the output signals from a reference signal oscillator 3 by a phase comparator 4, and the signal proportional to the phase difference is smoothed by a loop filter 5 to be inputted at the voltage controlled oscillator 1.

In such a construction with a phase locked loop structure (PLL), said signal proportional to phase difference is controlled to be small so as to obtain output signals of a stable frequency from the voltage controlled oscillator.

The methods to operate such a circuit intermittently can be roughly classified into two:

(1) Intermittent PLL operation: The operation of the voltage controlled oscillator 1 is kept to continue the operation, but a power source switch 9 (SW in the figure) is controlled by a controlling circuit 8 to supply power from the power source 7 intermittently to other circuits.

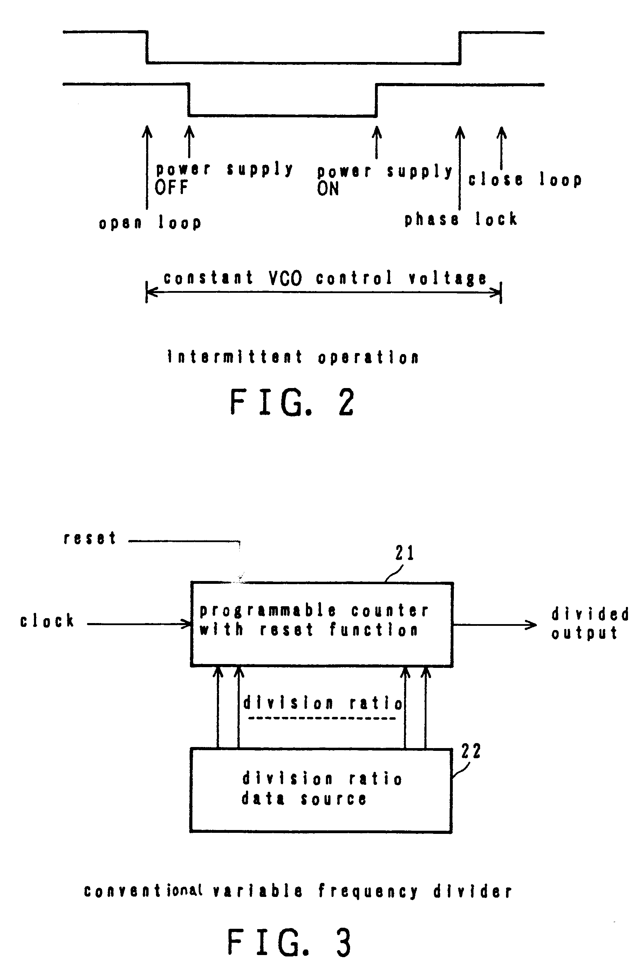

(2) Intermittent Oscillation Operation: The controlling circuit 8 controls the power source switch 9 so as to supply power intermittently to all the circuits including the voltage controlled oscillator 1. The controlling methods are identical to each other for both methods. The procedure is shown in FIG. 2.

When the power supply is suspended from respective circuits, the signals from the phase comparator 4 are blocked by a switch circuit 6 provided between the loop filter 5 and the phase comparator 4 in order to latch the controlling voltage which is stored in the loop filter 5 and supply to the voltage controlled oscillator 1. Then, the power supply is suspended for a predetermined period of time. If the power supply to circuits other than the voltage controlled oscillator 1 is suspended during the time, this becomes an intermittent operation. If the power supply to all the circuits including the voltage controlled oscillator 1 is suspended, this becomes an intermittent oscillation operation.

After resuming the power supply, the switching circuit 6 is closed to transmit the signals from the phase comparator 4 to the loop filter 5. If a difference in phase exists between the output signals from the variable frequency divider 2 and the output signals from the reference signal oscillator 3, the controlling voltage of the oscillator 1 which has been charged in the loop filter 5 fluctuates when the switching circuit 6 is closed.

Therefore, before closing the switching circuit 6, it is necessary to cause the phase of the output signals from the variable frequency divider 2 to coincide with the phase of the output signals from the reference signal oscillator 3. This can be achieved by two methods. One method comprises the steps of detecting the coincidence in the phases between the two and closing the switching circuit 6 while the other comprises the steps of causing the phases to coincide with each other by the phase circuit, and then closing the switching circuit.

As it is difficult to detect the coincidence in phases in the former method, a predetermined allowable phase difference is provided to facilitate signal detection. For example, phases can be made coincidental within the allowable difference of ca. 6 nano-sec. in a 800 MHz frequency synthesizer (phase comparator reference frequency in a phase comparator of 25 kHz).

The latter method releases reset signal at a variable frequency divider 2 with an edge of the output signal from the reference oscillator 3, for instance, to start the dividing operation. As the phase difference in this case is equivalent to one cycle of input signals, it becomes ca. 1.3 nsec in the 800 MHz frequency synthesizer. The method, however, inevitably adds a delay to the phase difference if entailed in the control circuit 8.

A programmable frequency divider suitable for use in the frequency synthesizer will now be described in more detail.

FIG. 3 is a block diagram to show the basic structure of a programmable frequency divider which comprises a programmable counter 21 with reset function to vary division ratio, and a division ratio data generator 3.

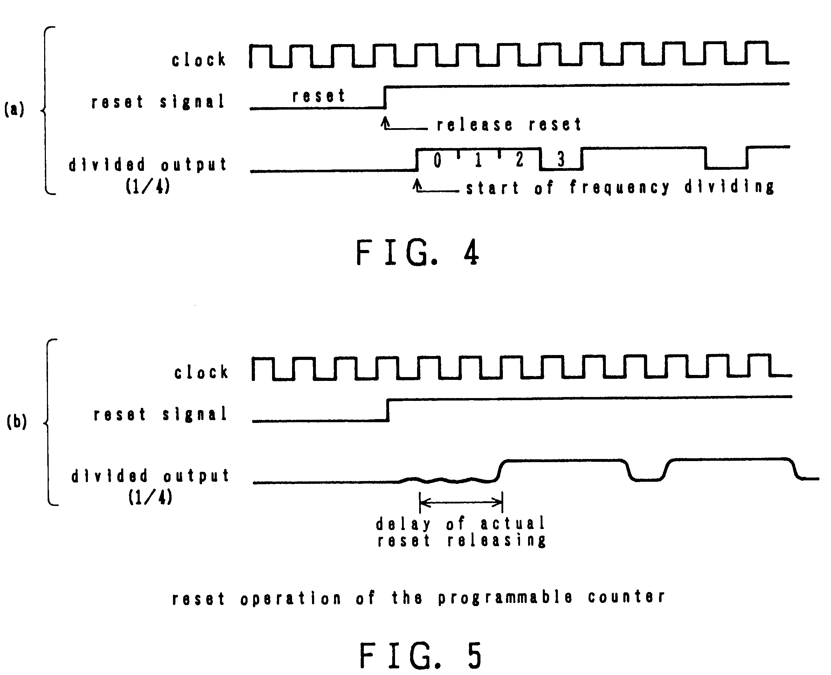

FIGs. 4 and 5 show the resetting operation of the programmable counter. If a division ratio n is set in advance, it starts frequency dividing operation with the division ratio $\underline{n}$ immediately after reset signal is suspended. The operation of the circuit is equivalent to that of a programmable counter, and outputs at low level only when the counted value becomes (3), and outputs at high level at other times. While it is being reset the level is low. As is obvious from the figures, the delay time from the release of the reset signal to the time when the dividing operation is actually started is equivalent to one cycle of the input clocks. But when the clocks are of an extremely high speed, release of the reset signals is delayed for some time before they are actually realized in the operation of the programmable frequency divider. As shown in FIG. 5, the delay time may sometimes extend longer than the one cycle of the input clocks before the start of the dividing operation.

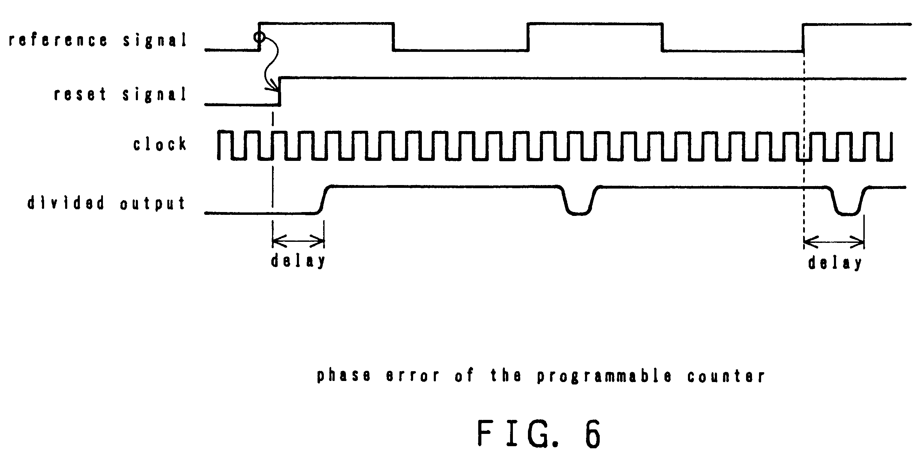

As shown in FIG. 6, when frequency division is started with a higher frequency clock locked with the reference signal to generate a frequency dividing signal with the phase locked with the phase of the reference signal, the above mentioned delay time per se becomes the difference in phase. If it is desirable to synchronize the phase of frequency divided output, a frequency divider should have a preset function. The term "preset" as used herein denotes a function to set internal conditions arbitrarily when frequency dividing operation starts.

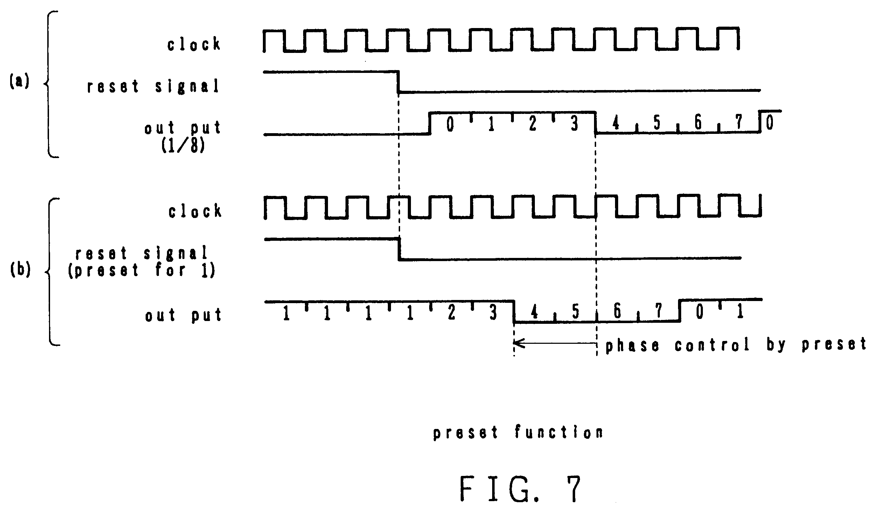

FIG. 7 shows examples of a preset counter to compare the reset function with the preset function.

FIG. 7a shows the state when the reset function is used. The frequency divider output stays at a low level during resetting operation, and becomes pulses of 50% duty ratio after the reset is released. FIG. 7b shows the state when the preset function is used. For instance, when it is preset at (1), the frequency divider output is at a high level corresponding to the (1) when the preset is ON, and starts counting clocks from there.

As shown in FIG. 7, when the preset is released to resume frequency dividing operation, if the internal state is preset in advance to be deviated by the number of the input clocks equivalent to the delay, the output from the frequency divider becomes synchronized with the reference signal with the difference within one cycle of input clocks.

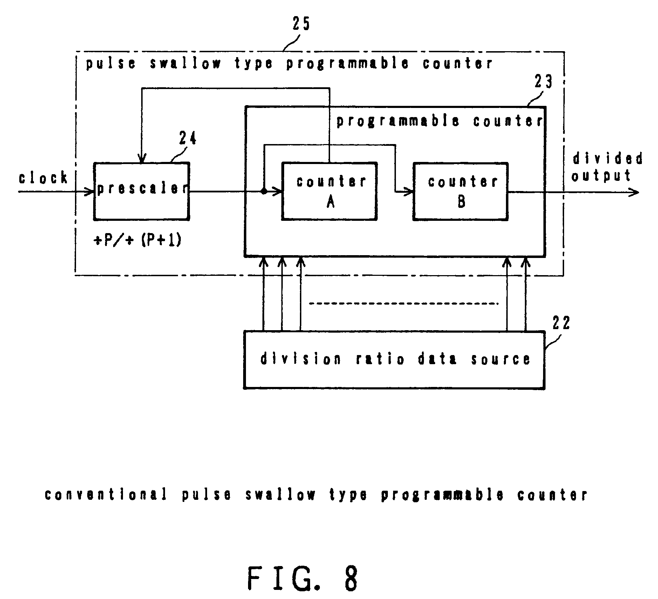

FIG. 8 is a block diagram to show the basic structure of a programmable frequency divider using a pulse swallow type programmable counter which comprises a division ratio data generator 22, and a pulse swallow type programmable counter 25 having a programmable counter 23 incorporating counter A and B and a pre-scaler 24 which can switch division ratio between P and P+1. The programmable counter 23 counts the output pulse from the pre-scaler 24 with the counters A and B simultaneously. The division ratio is set at P+1 at the pre-scaler 24.

It is assumed here that the division ratio of the counter A and the counter B are $\underline{a}$ and $\underline{b}$ respectively (b > a). The counter A counts the output pulses from the pre-scaler 24 in the number of $\underline{a}$, outputs pulses to the pre-scaler 24, revises the division ratio from P+1 to P, and suspends counting.

The counter B counts the output pulses from the pre-scaler 24 in the number of $\underline{b}$ before outputting pulses, but the number $\underline{a}$ out of the pulses is of the frequency divided by $\underline{P+1}$ while the number of $\underline{b - a}$ is of the frequency divided by P. The division ratio N is expressed as below;

$$N = a(P + 1) + (b - a)P = bP + a$$

Whenever the counter B outputs a pulse, both counters A and B and the pre-scaler 24 are reset.

The division ratio of the pre-scaler 24 was set again at $\underline{P + 1}$. This pulse swallow type programmable counter is generally used for frequency synthesizers of several tens MHz or higher. When the frequency of the input clock is high, 1/4 or 1/8 radio frequency fixed counters (RF-fixed counters) are generally provided at the stage prior to a programmable counter as a radio frequency-counter. In such a case, the division ratio inevitably becomes a multiple of 4 or 8 making the frequency control with a finer precision difficult. But if the frequency is not so high, this pulse swallow method can divide frequency directly and change the frequencies in the whole system separately from each other.

Even in the case of pulse swallow type programmable counters as described above, the phase of the output from the frequency divider can be, as a principle, locked with the reference signal by adding aforementioned preset function.

However, it is extremely difficult, in practice, to add such preset function to a variable frequency divider or to the pulse swallow type programmable counter although addition of such preset function is quite easy in fixed frequency dividers.

More particularly, in order to add a preset function to a pulse swallow type programmable counter, the pre-scaler should have a preset function, too. But the addition of a preset function to a pre-scaler for the frequency as high as 1 GHz - 3 GHz would increase the operation speed and power consumption to thereby deteriorate performance.

Moreover, as the programmable counter has already been equipped with a preset function in order to construct a programmable frequency divider, and addition of another preset function would pose a difficulty.

This invention was contrived to eliminate these problems of prior art frequency synthesizers and has as an object the provision of a frequency capable of achieving rapid lock.

French Patent Application No. 2 128 056 (FR-A-2 128 056) and its counterpart British Patent No. 1 333 534 (GB 1 333 534) disclose a phase locked loop (PLL) frequency synthesizer which is capable of operating at frequencies determined by a range of division ratios denoted by N, provided by a variable divider, in which a control circuit for the variable divider sets a division ratio of N + e for a short period before setting the division ratio to N, where K is an integer greater than unity and e is zero or is small compared with N .

The PLL frequency synthesizer disclosed in FR-A-2 128 056 and GB 1 333 534 generates an output signal which is N times the frequency of a reference signal and in phase with the reference signal, when its variable divider is set to N, and generates an output signal that changes phase relative to the reference signal during the short period when its variable divider is set to N + e.

Reference is also made to the document EP-A-0 211 594 (published 25.2.1987) disclosing a frequency synthesizer as set out in the opening portion of Claim 1.

The present invention provides a frequency synthesizer for generating an output signal which has a set frequency which is a multiple of the frequency of a reference signal and has less than a predetermined phase difference from the reference signal, the set frequency signal being established with less than the predetermined phase difference from the reference signal by generating an output signal of a frequency providing phase movement relative to the reference signal and terminating operation at the frequency providing phase movement by switching to the set frequency, characterised in that, in operation, the frequency synthesizer maintains its operation at the set frequency if, on switching to the set frequency, the phase difference between the set frequency signal and the reference signal is less than the predetermined phase difference, and reverts to operation at a frequency providing phase movement relative to the reference signal for a further period if, on switching to the set frequency, the phase difference between the set frequency signal and the reference signal is not less than the predetermined phase difference.

One embodiment of the invention is a frequency synthesizer which, during the further period of operation at a frequency providing phase movement relative to the reference signal, operates at the same frequency used initially for providing phase movement relative to the reference signal.

Another embodiment of the invention is a frequency synthesizer which, during the further period of operation at a frequency providing phase movement relative to the reference signal, operates at a frequency different from that used initially for providing phase movement relative to the reference signal.

Preferably, the frequency synthesizer of either embodiment includes a voltage controlled oscillator, a control system for the voltage controlled oscillator and means for switching on and switching off the control system so arranged that, in operation, the control system is first switched on briefly while set to operate the voltage controlled oscillator at a frequency providing phase movement relative to the reference signal, the voltage controlled oscillator is allowed to operate with phase movement relative to the reference signal with the control system switched off, and the operation of the voltage controlled oscillator with phase movement relative to the reference signal is terminated by again switching on the control system, with that system set to operate the voltage controlled oscillator at the set frequency.

Preferably, the frequency synthesizer of either embodiment includes a control system having a loop filter which, in operation, stores a control voltage while the control system is switched on and supplies the control voltage to the voltage controlled oscillator while the control system is switched off, and a phase detector which, in operation, detects the phase relationship between the output of the voltage controlled oscillator and the reference signal and controls the switching on of the control system to terminate operation with phase movement relative to the reference signal.

An embodiment of the invention may be a frequency synthesizer comprising:

a voltage controlled oscillator,

a variable divider having an input which is connected to the output of the voltage controlled oscillator and which, in operation, divides the signal from the voltage controlled oscillator by a division ratio which is variable,

a reference signal oscillator which generates an output waveform which has edges,

a phase comparator which is connected to receive the output signal of the variable divider and the output signal of the reference signal oscillator and which, in operation, compares those signals with each other and provides an output signal dependent on the result of the comparison,

a loop filter which is connected to receive the output signal from the phase comparator and which, in operation, smooths the signal and applies the smoothed signal, as a control signal, to the voltage controlled oscillator,

a phase detector which is also connected to receive the output signal from the variable divider and the output signal from the reference signal oscillator and which, in operation, compares those signals with each other and provides an output signal dependent on the result of the comparison and

a control loop including a switch circuit positioned to establish, and to remove, a connection between the phase comparator and the loop filter, which control loop is connected to receive the output signal from the phase detector,

wherein, in operation,

first, the internal condition of the variable divider is reset by setting it to divide by a division ratio $n_1$,

then, the phase comparator is connected to the loop filter through the switch circuit,

then, an edge of the output from the reference signal oscillator is detected to release the reset condition of the variable frequency divider, allowing it to divide by the division ratio $n_1$,

then, the phase comparator output signal is latched at the loop filter by connecting the phase comparator briefly to the loop filter,

then, after the variable divider has completed the first cycle of division,

the variable divider is set to divide by a division ratio N, and the phase detector detects the phase difference between the signal from the reference oscillator and the output signal from the variable divider and,

if the phase detector detects that the signal from the reference oscillator and the output signal from the variable divider differ in phase by less than a predetermined amount, the phase comparator is connected to the loop filter and the variable divider remains set to divide by the division ratio N, and,

if the phase detector detects that the signal from the reference oscillator and the output signal from the variable divider do not differ in phase by less than the predetermined amount, the variable frequency divider is reset, again, and the operations carried out previously, from the resetting of the variable divider to its being set to divide by the division ratio N, are repeated, until the phase detector detects that the said phase difference is less than the predetermined amount, when the phase comparator is connected to the loop filter and the variable divider remains set to divide by the division ratio N.

Preferably, the variable divider includes a division ratio data source connected to a division ratio data latch circuit which, in turn, is connected to a programmable counter, which division ratio data source, in operation, generates first control input data, for storage by the division ratio data latch circuit and transmission to the programmable counter, for the generation of an output signal of frequency providing phase movement relative to the reference signal, and provides second control input data, for storage by the division ratio data latch circuit and transmission to the programmable counter, for the generation of an output signal at the set frequency.

A frequency synthesizer in accordance with the invention is such that, even with intermittent operation, phase error is kept constantly under the reference value.

Therefore, irrespective of fluctuation in temperature and voltage, this invention synthesizer can establish phase lock of the loop constantly at a high speed with minimal frequency fluctuation.

This invention is a practically effective means for intermittently operating frequency synthesizers and can achieve reduction of power consumed in the frequency synthesizer.

This invention further permits fast channel switching by charging the control voltage of the voltage controlled oscillator which corresponds to other oscillation frequency at a loop filter at a high speed while the input from the phase comparator is being blocked from the loop filter, and by setting the division ratio $\underline{N}$ at the variable frequency divider corresponding to the frequency.

The frequency synthesizer of this invention can effectively reduce the power consumption when applied to mobile radio communications, satellite communications, terrestrial microwave communications and other systems which operate with radio frequency. For instance, the invention synthesizer may be used in intermittent receiving in an NTT high capacity land mobile communication system to extend the time available from the battery per one charge by 1.5 times. It can reduce power consumption by even a larger margin in a radio communication system of a smaller output power such as office cordless phone systems. This invention method can switch channels at higher speed by charging at a high speed the control voltage of the voltage controlled oscillator corresponding to another oscillation frequency at a loop filter while blocking the input from the phase comparator from the loop filter and setting a division ratio of the variable frequency divider corresponding to the particular frequency.

All the control circuits according to this invention can be constructed with digital ICs to facilitate large scale integration without necessity of adjustment.

(Brief Description of the Drawings)

FIG. 1 is a block diagram to show the basic structure of a prior art frequency synthesizer for intermittent operation.

FIG. 2 is a chart to show the procedure of intermittent operation.

FIG. 3 is a block diagram to show the basic structure of a programmable frequency divider circuit.

FIG. 4 is a timing chart of the reset operation at the programmable counter with the rest function.

FIG. 5 is a timing chart to show the reset operation of a programmable counter with the reset function.

FIG. 6 is a timing chart to explain synchronization difference of the programmable counter with the reset function.

FIG. 7 is a timing chart to explain the preset function.

FIG. 8 is a block diagram to explain the basic structure of a pulse swallow type programmable counter.

FIG. 9 is a timing chart to explain operation with preset as used in a frequency synthesizer according to the invention.

FIG. 10 is a block diagram of a first embodiment of a programmable frequency divider circuit for a frequency synthesizer according to the invention.

FIG. 11 is a timing chart to explain operation with preset for the embodiment shown in Fig. 10.

FIG. 12 is a block diagram of a second embodiment of a programmable frequency divider circuit for a frequency synthesizer according to the invention.

FIG. 13 is a timing chart to explain operation with preset for the embodiment shown in Fig. 12.

FIG. 14 is a block diagram of an embodiment of a frequency synthesizer according to the invention.

FIG. 15 is a time chart to show the operation of the embodiment shown in Fig. 14.

FIG. 16 is a chart to show an example of the structure of a phase difference detection circuit included in Fig. 14.

FIG. 17 is a chart to show the relation between input signals and output signals at the phase difference detection circuit shown in Fig. 16.

FIG. 18 is a view to show an embodiment of a switch circuit included in Fig. 14.

FIG. 19 is a view to show an alternative embodiment of a switch circuit for Fig. 14.

FIG. 20 is a view to show the results of frequency fluctuation under intermittent operation for synthesizers without phase matching and those with phase matching according to the invention.

FIG. 21 is a view to show control of the frequency synthesizer according to the invention when the power source is switched on and off repeatedly.

(Preferred Mode to Embody the Invention)

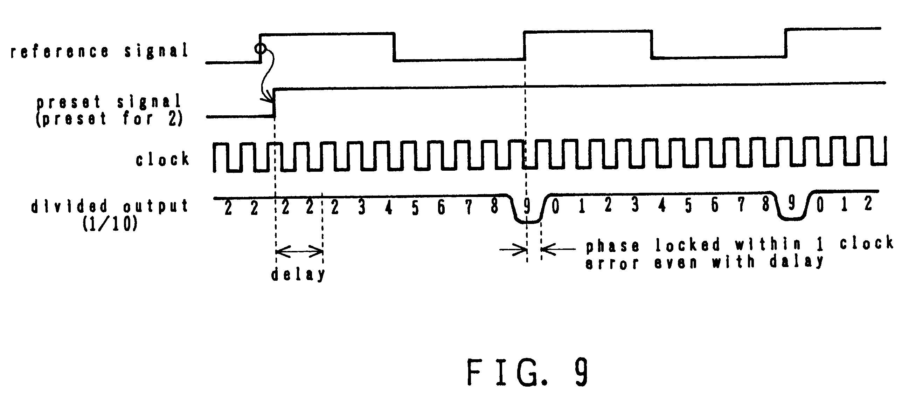

FIG. 9 is a timing chart to show the operation of a programmable frequency dividing circuit which is preset at (2). In the chart, it is obvious that in the second cycle and thereafter the operation is conducted normally with the division ratio of 10. By selecting an appropriate preset value, the duration of time before the circuit starts the normal dividing operation can be set arbitrarily (in the unit of clock cycles). This circuit can realize preset functions with different division ratios for the first cycle as well as for the second cycle and thereafter.

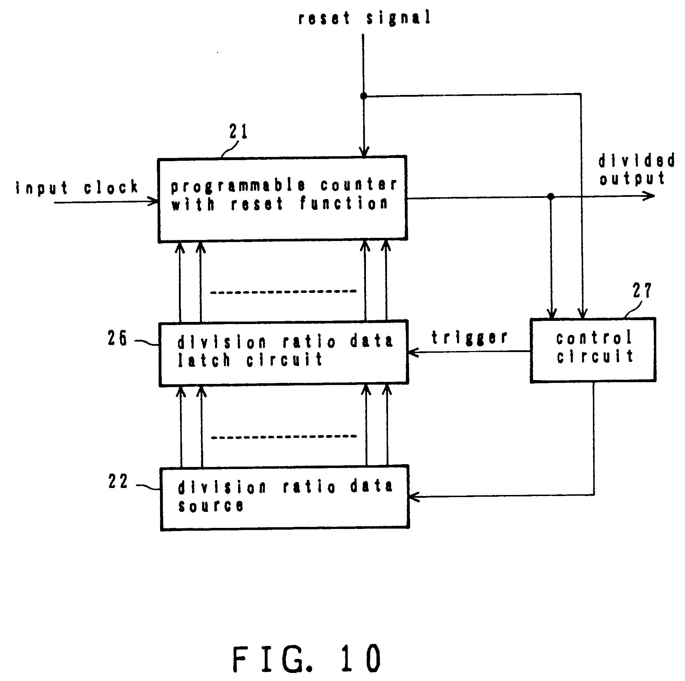

FIG. 10 is a block diagram to show a first embodiment of the programmable frequency divider circuit. The reference numeral 21 denotes a programmable counter with reset function, and 22 a division ratio data generator. The reference numeral 26 denotes a division ratio data latch circuit which temporarily retains the division ratio data output from the generator 22 and sends the data to the programmable counter 21 when a trigger signal is received, and 27 a controlling circuit.

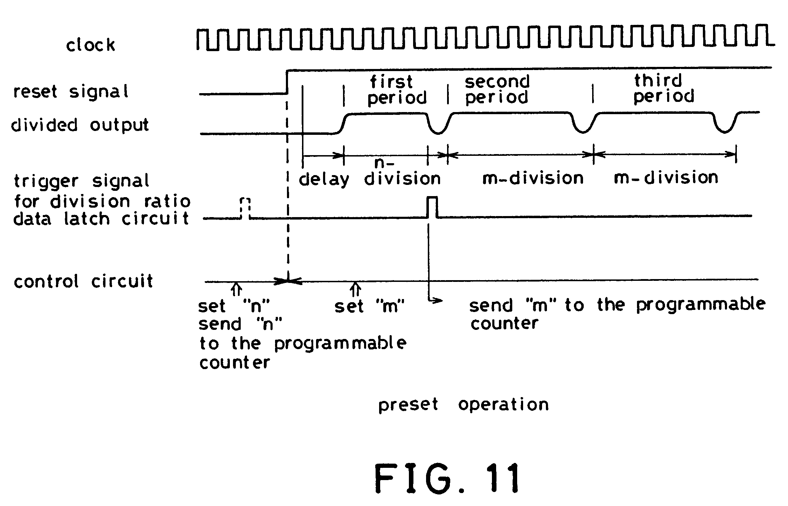

FIG. 11 shows a timing chart of the operation with preset of the circuit shown in Fig. 10. When it is reset, the output from the programmable counter 21 is either at a high level or a low level. In the meanwhile, the division ratio $n$ generated by the generator 22 is set at the latch circuit 26, then a trigger signal is fed to the latch circuit 26 to set the division ratio at $n$ in the programmable counter 21.

When the reset is released and a frequency dividing operation is started, the operation is conducted with the division ratio of $n$ for the first cycle. By the time the internal condition progresses by the number of $n$ inside the programmable counter 21 a new division ratio $m$ is generated by the generator 22. When the counting of the $n$th input clock is detected, a trigger signal is fed to the latch circuit 26, and the division ratio of the programmable counter 21 is changed to $m$ within a cycle of the input clock.

The frequency is therefore divided with the ratio $m$ in the second cycle and thereafter.

If $n$ is selected arbitrarily in the above operation, the first cycle can be made programmable, and the initial phase at the time of releasing the reset can be adjusted in the unit of input clock cycles. The programmable counter has the output signals equivalent to the preset function as it is of a low level for only one cycle of the input clock and the duty ratio is negligible.

In this embodiment, the latch circuit 26 stores temporarily the division ratio data and supplies the same to the programmable counter 21 at a timing that does not cause malfunctioning of the programmable counter 21. The latch circuit 26 is, however, not always necessary. For instance, the division ratio data generated from the data generator 22 may be directly supplied to the programmable counter 21 if the division ratio data is to be taken only when the reset state is released, or when a dividing operation for one cycle is completed.

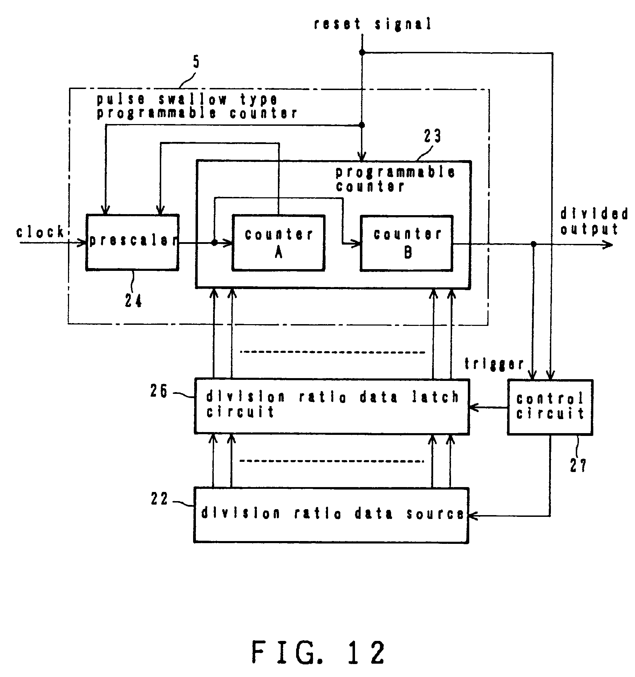

FIG. 12 is a block diagram to show a second embodiment of the programmable frequency divider.

In this embodiment, instead of the programmable counter 21 with reset function, a pulse swallow type programmable counter 25 comprising a pre-scaler 24 which can switch the division ratio between $P$ and P+1, and a programmable counter 23 (with reset function) incorporating a counter A (division ratio $a$) and a counter B (division ratio $b$) are used. The pulse swallow type programmable counter 25 is similar to a well known counter capable of the operations mentioned above.

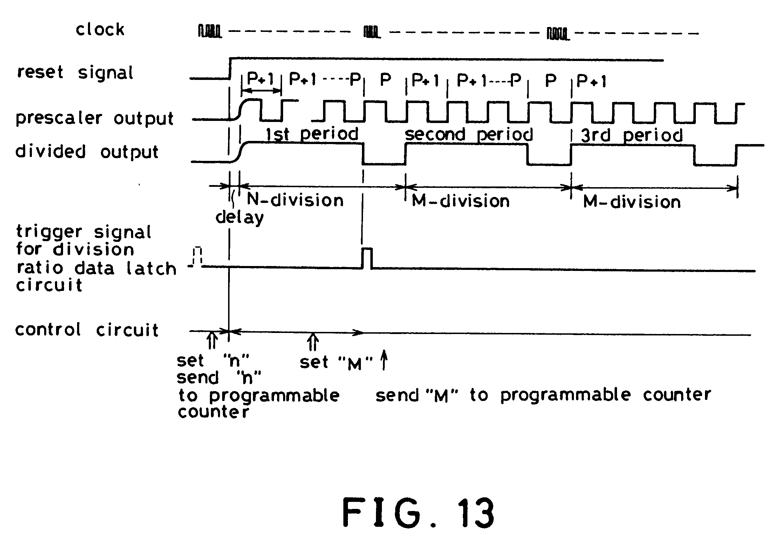

FIG. 13 shows a timing chart of the preset operation of this embodiment. When the pre-scaler 24 and the programmable counter 23 are reset simultaneously, the outputs from the pre-scaler 24 and the counter 23 are set at either a high level or a low level. Meanwhile, the division ratio $n$ is set by the data generator 22, and a trigger signal is fed to the latch circuit 26. Then the division ratio of the pulse swallow type programmable counter 25 comprising the pre-scaler 24 and the programmable counter 23 is set at $n$, and the division of the pre-scaler 24 is set at P+1 simultaneously.

More specifically, the counter A within the programmable counter 23 is for changing the division ratio of the pre-scaler 24 and does not concern the division ratio of the whole system. When it receives the division ratio data $n$ from the latch circuit 26, the counter adjusts the division ratio for the pre-scaler 24 and the counter B in a manner to make the division ratio of the system $n$. Therefore, the latch circuit 26 may be the same circuit as the one used in the first embodiment of the programmable frequency divider.

After the reset is released and the dividing operation starts, the pulse swallow type programmable counter 25 divides for the first cycle by counting the number $n$ of input clocks while changing the division ratio of the pre-scaler 24 from P+1 to P. The counter B of the counter 23 counts the output pulses in the number $b$ of the pre-scaler 24 (provided that n = bP + a.)

In the dividing operation, by the time the programmable counter 23 has counted the number $b$ of output pulses of the pre-scaler 24, the control circuit 24 newly generates a division ratio $m$ at the data generator 23. Subsequently, the control circuit 24 detects that the circuit 23 has counted the number $b$ of output pulses from the pre-scaler 24, feeds a trigger signal to the latch circuit 26, and changes the division ratio of the counter 25 to $m$ within one cycle of the output pulses of the pre-scaler 24. The pulse swallow type programmable counter 25 conducts the dividing operation with the division ratio $m$ from the second cycle and thereon.

By selecting the number $n$ arbitrarily, it is possible to change the cycle of dividing operation of the first cycle in the counter 25, and to adjust the initial phase by the unit of the clock cycles input from the pre-scaler 24 after the reset is released.

The time allowable from the output is triggered for the first cycle and to the change of division ratio to $m$ at the programmable counter 21 is within one cycle of the input clocks in the first embodiment. In the second embodiment, on the other hand, the allowable time of the pulse swallow type counter 25 is equivalent to one cycle of input clocks of the circuit 23 or the value equivalent to P+1 times of the input clock of the pre-scaler 24.

If the input clocks are identical in the first and second embodiments, therefore, the allowable time of the second embodiment becomes P+1 times as much as the first embodiment.

Similarly to the first embodiment, as the cycle of the dividing operation can be changed from the first cycle in the unit of clock cycle in this embodiment, it can achieve the effect similar to the preset function.

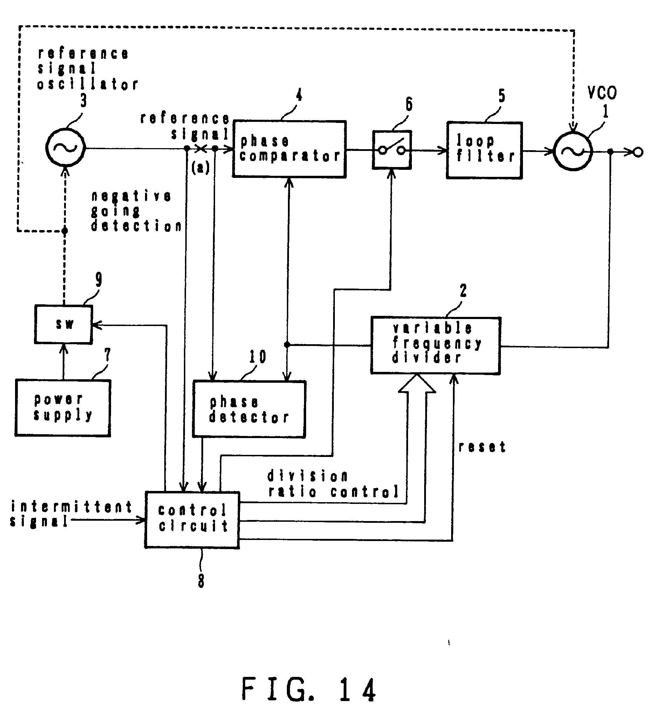

If the second embodiment is used as the variable frequency divider 2 of the frequency synthesizer shown in FIG. 14, then delay is caused by the gate circuit from detection of output signals of the reference oscillator 3 by the controller 8 and reset of the circuit 2 (generally in the order of several tens nsec). The initial phase of the pre-scaler and the programmable counter outputs can be adjusted in units of input clock cycles. This allows offsetting of the delay without an analogue delay circuit.

For instance, if it is assumed that the frequency of the voltage controlled oscillator is 1 GHz, the delay can be adjusted for every 1 nsec (= 1/1 GHz).

The aforementioned programmable frequency dividing circuit can be structured fully with digital ICs. Further, the whole system of the frequency synthesizer can be integrated with ICs.

FIG. 14 is a block diagram of an embodiment of a frequency synthesizer according to the invention. The reference numeral 1 denotes a voltage controlled oscillator (abbreviated as VCO in the figure), 2 a variable frequency divider, 3 a reference signal oscillator, 4 a phase comparator, 5 a loop filter, 6 a switch circuit, 7 a power source, 8 control circuit, 9 a power switch (SW), and 10 a phase detector.

The variable frequency divider 2 has the preset function to conduct dividing operation with $n$ only in the first cycle after the reset condition is released, and with $N$ in the second cycle and thereafter. The phase detector 10 is a circuit to detect the phase difference between the output signals from the reference signal oscillator 3 and the output signals from the variable frequency divider 2.

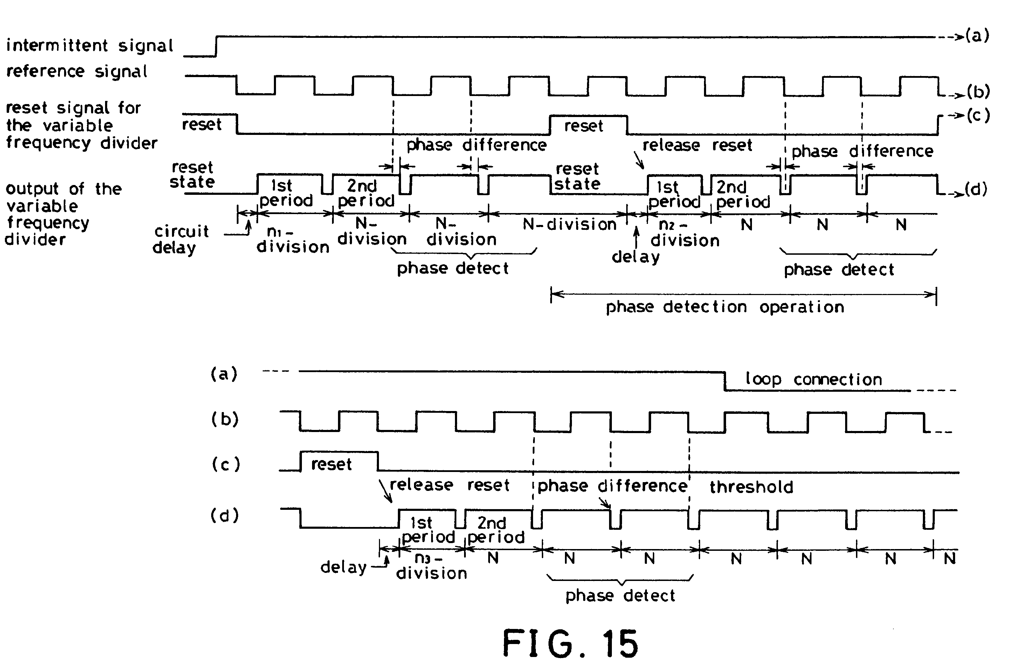

FIG. 15 is a time chart to show an example of operation of the embodiment shown in FIG. 14.

The operation will now be described referring to FIGs. 14 and 15.

When a loop is formed by closing the switch circuit 6 in this invention frequency synthesizer, the control voltage of the voltage controlled oscillator 1 is latched at the loop filter 5. The control voltage corresponds to the oscillated signal frequency outputted from the voltage controlled oscillator 1. In order to latch the control voltage at the loop filter 5, the voltage may be charged from outside or latched by opening the loop after the phase lock loop has been formed.

Before closing the loop, the internal condition of the variable frequency divider 2 is reset to have the division ratio $n$ at $n_1$ in the first phase difference detecting operation, and then the condition of the variable frequency divider 2 is released when a negative going edge is detected in the outputs of the reference signal oscillator 3 to conduct the dividing operation with $n_1$ for the first cycle alone. At the second cycle and thereafter, the dividing operation is conducted with N for a certain period. The cycle herein means the cycle of the output signals from the variable frequency divider 2.

While conducting this dividing operation, the phase detector 10 detects the difference in phase between the output from the reference signal oscillator 3 and the outputs from the variable frequency divider 2 having the division ratio of N. If the phase difference is a reference value or higher, the division ration $n$ is reset to $n_2$ in the variable frequency divider 2, and then the phase difference detection will be resumed for the second time.

More particularly, the variable frequency divider 2 is reset again to conduct the same operation as the first one. If the phase difference is still above the reference value, then the division ratio $n$ is set at $n_3$ to repeat the operation.

The above operation is repeated until the time the phase difference between the output signals from the reference oscillator 3 and from the variable frequency divider 2 becomes smaller than one cycle of the voltage controlled oscillator output signal, and the switch circuit 6 is closed immediately after the final detection of the phase difference to form a closed circuit.

As the phase difference becomes less than one cycle of the input signals from the variable frequency divider 2 final detection, if a closed loop is formed immediately after that, the fluctuation of the frequency seldom occurs to establish a stable phase locked loop. In the subsequent intermittent operation of the power source, the division ratio $n$ of the variable frequency divider remains at the value of the final phase difference detection unless the phase difference output from the detector 10 becomes larger than the reference value.

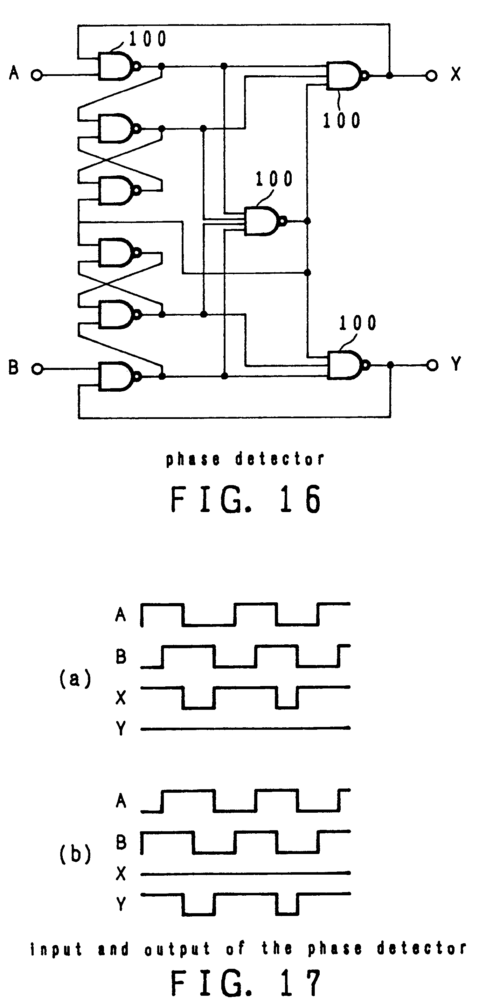

FIG. 16 is a circuit diagram of an embodiment of the phase difference detector 10. This may be a well known circuit comprising nine NAND circuits 100 which compares the phases of the input signals A and B to output the result.

For instance, when the phase of an input signal A is advanced ahead of the input signal B, an advance signal is outputted to a terminal X as shown in FIG. 17a while when the phase of the input signal A is behind the input signal B, a delay signal is outputted to a terminal Y as shown in FIG. 17b. When both phases of the signals A and B coincide, neither signal is issued.

In the circuit, if the output signal from the reference signal oscillator 3 is assumed to be an input signal A and the output signal from the variable frequency divider 2 is assumed to be an input signal B, the phase of the output signals of the variable frequency divider 2 can be detected whether it is ahead of or behind the phase of the output signals of the reference oscillator.

Therefore, if this circuit is used as the phase detector 10 shown in FIG. 14 and when the phase of the output signal of the variable frequency divider 2 is detected to be ahead of the phase of the output signals from the oscillator 3 at the second phase difference detection after the division ratio $n$ of the variable frequency divider 2 has been set at $n_1$ at the first phase difference detection, $n_2$ which is larger than $n_1$ can be set as the division ratio. When it is detected to be behind, $n_2$ which is smaller than $n_1$ should be set as the division ratio $n$.

The division ratio $n$ may be set by gradually increasing/decreasing the value, or increasing the convergence speed of the division ratio $n$ by changing the rate of change. In both cases, the values will be converged to one single value if the value $n$ is controlled to be between the value $n_i$ showing the phase ahead and the value $n_j$ showing the phase behind. Actual phase difference at the time becomes less than one cycle of input signals of the variable frequency divider. It is ca. 1.3 nsec in a 800 MHz band frequency synthesizer.

Even if an allowable error $\pm 1$ is given to $n$ in order to enhance the convergence, the phase difference will remain small enough not to generate significant frequency fluctuation. When a convergence test was conducted for the division ratio $n$ using this phase difference detector, it was confirmed that the values converged to one single value.

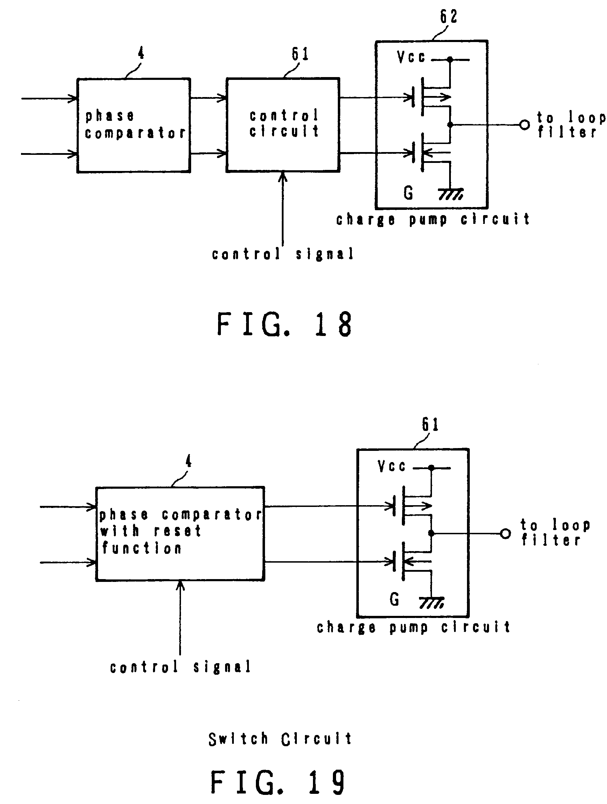

FIGs. 18 and 19 are block diagrams to show an embodiment of a switch circuit 6 which is provided with a charge pump circuit 62 to increase the impedance of the output.

In the circuit shown in FIG. 18, a control circuit 61 is inserted between the phase comparator 4 and a charge pump circuit 62. In the circuit shown in FIG. 19, a reset function is provided within the phase comparator 4 to reset the internal condition of the circuit 4 so that the output signals therefrom can increase the impedance of the output from the charge pump circuit 62.

In order to confirm the operation by this embodiment, an intermittent operation test was conducted with a 800 MHz band frequency synthesizer.

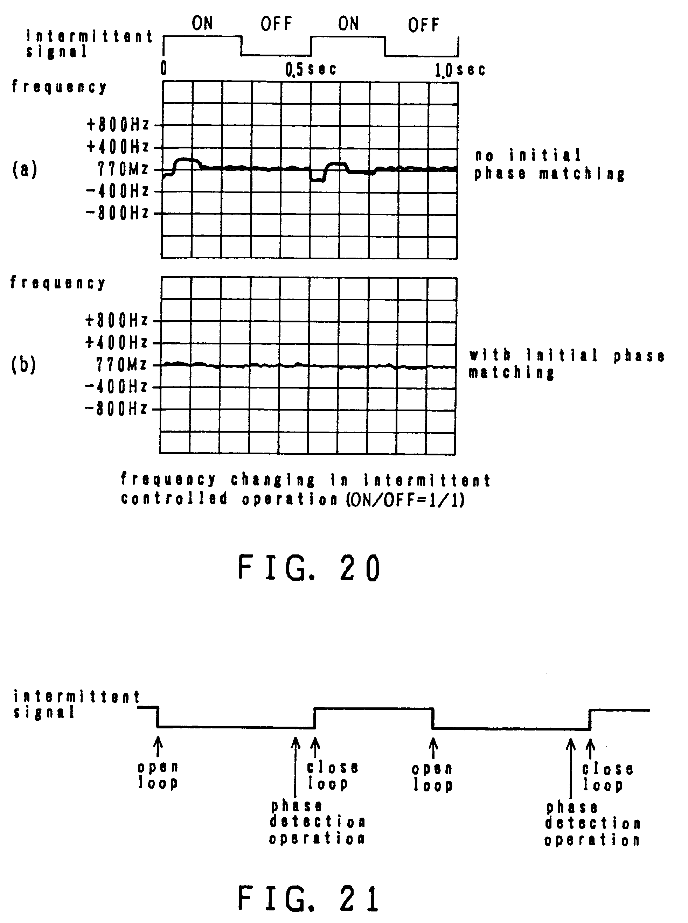

FIG. 20 explains the result of the test; the frequency fluctuation occurred when the power source of the variable frequency divider and of reference signal oscillator was intermittently connected in an intermittent PLL operation.

As is clear from the figure, when this embodiment is not used, the frequency fluctuated remarkably as shown in FIG.20a with the power supply; but with the use of this embodiment, almost no fluctuation of frequency occurred as is evident from FIG. 20b.

FIG. 21 shows an example of the operations where the power is supplied intermittently by the above embodiment.

For repeatedly switching the loop ON/OFF, the switch circuit should be opened first to latch the control voltage of the voltage controlled oscillator immediately before the opening of the loop at the loop filter. For the intermittent operation, the power source of the circuit should be cut OFF for a predetermined period. Then, the phase difference detection mentioned above is repeated more than once to set the division ratio $n$ for the variable frequency divider before connecting the switch circuit to close the loop. Similar operation is repeated in the subsequent switching of the loop to control the phase difference between the output from the reference oscillator and the output from the variable frequency divider to be constantly less than one cycle of the voltage controlled oscillator output signal.

Especially when a phase difference larger than one cycle of the voltage controlled oscillator output signal is generated between the output signals from the reference signal oscillator and from the programmable counter due to fluctuations in temperature or electric voltage after the final $n$ has been set to start such an intermittent operation, this invention control is most advantageous to make the phase difference constantly less than one cycle of the voltage controlled output signal.

Although the description in the foregoing statement is related to the case where the phase difference is reduced only by controlling the division ratio, the same result may be attained by insertion of a delay circuit at the point (a) in FIG. 14 so that the reference signal to be supplied to the phase comparator 4 and the phase detector 10 is delayed behind the reference signal to be supplied to the control circuit 8. For that purpose, a delay circuit suitable for the delay required by the control circuit 8 is attached at the time of fabrication so that the fluctuation in delay due to the fluctuation in temperature or electric voltage is offset by the control of the division ratio.

In a specific embodiment of the invention, counter 21 consists of an integrated circuit known as IC74161 whilst source 22 may consist of several such integrated circuits. Counter 25 comprises a programmable counter 23 in the form of an integrated circuit known under the designation NECupD2833C and a prescaler 26 in the form of an integrated circuit known under the designation NECupB566C. The latch circuit also consists of several of the integrated circuits IC74374 whilst the control circuit 27 comprises a personal computer PB9800.

## Claims

1. A frequency synthesiser for generating an output signal which has a set frequency which is a multiple of the frequency of a reference signal and has less than a predetermined phase difference from the reference signal, the set frequency signal being established with less than the predetermined phase difference from the reference signal by generating an output signal of frequency providing phase movement relative to the reference signal and terminating operation at the frequency providing phase movement by switching to the set frequency, characterised in that, in operation, the frequency synthesiser maintains its operation at the set frequency if, on switching to the set frequency, the phase difference between the set frequency signal and the reference signal is less than the predetermined phase difference, and reverts to operation at a frequency providing phase movement relative to the reference signal for a further period if, on switching to the set frequency, the phase difference between the set frequency signal and the reference signal is not less than the predetermined phase difference.

2. A frequency synthesiser as claimed in claim 1, which, during the further period of operation at a frequency providing phase movement relative to the reference signal, operates at the same frequency used initially for providing phase movement relative to the reference signal.

3. A frequency synthesizer as claimed in claim 1, which, during the further period of operation at a frequency providing phase movement relative to the reference signal, operates at a frequency different from that used initially for providing phase movement relative to the reference signal.

4. A frequency synthesizer as claimed in any one of claims 1 to 3, which includes a voltage controlled oscillator (1), a control system (2,4,5,8,10) for the voltage controlled oscillator (1) and means (6) for switching on and switching off the control system (2,4,5,8,10) so arranged that, in operation, the control system (2,4,5,8,10) is first switched on briefly while set to operate the voltage controlled oscillator (1) at a frequency providing phase movement relative to the reference signal, the voltage controlled oscillator (1) is allowed to operate with phase movement relative to the reference signal with the control system (2,4,5,8,10) switched off, and the operation of the voltage controlled oscillator (1) with phase movement relative to the reference signal is terminated by again switching on the control system, (2,4,5,8,10) with that system set to operate the voltage controlled oscillator at the set frequency.

5. A frequency synthesizer as claimed in claim 4, wherein the control system (2,4,5,8,10) includes a loop filter (5) which, in operation, stores a control voltage while the control system (2,4,5,8,10) is switched on and supplies the control voltage to the voltage controlled oscillator (1) while the control system is switched off, and a phase detector (10) which, in operation, detects the phase relationship between the output of the voltage controlled oscillator (1) and the reference signal and controls the switching on of the control system (2,4,5,8,10) to terminate operation with phase movement relative to the reference signal.

6. A frequency synthesizer as claimed in claim 1, comprising:

a voltage controlled oscillator (1),

a variable divider (2) having an input which is connected to the output of the voltage controlled oscillator (1) and which, in operation, divides the signal from the voltage controlled oscillator (1) by a division ratio which is variable,

a reference signal oscillator (3) which generates an output waveform which has edges,

a phase comparator (4) which is connected to receive the output signal of the variable divider (2) and the output signal of the reference signal oscillator (3) and which, in operation, compares those signals with each other and provides an output signal dependent on the result of the comparison,

a loop filter (5) which is connected to receive the output signal from the phase comparator (4) and which, in operation, smooths the signal and applies the smoothed signal, as a control signal, to the voltage controlled oscillator (1),

a phase detector (10) which is also connected to receive the output signal from the variable divider (2) and the output signal from the reference signal oscillator (3) and which, in operation, compares those signals with each other and provides an output signal dependent on the result of the comparison and

a control loop (2,4,6,8,) including a switch circuit (6) positioned to establish, and to remove, a connection between the phase comparator (4) and the loop filter (5), which control loop (2,4,6,8) is connected to receive the output signal from the phase detector (10),

wherein, in operation,

first, the internal condition of the variable divider (2) is reset by setting it to divide by a division ratio $n_1$,

then, the phase comparator (4) is connected to the loop filter (5) through the switch circuit (6),

then, an edge of the output from the reference signal oscillator (3) is detected to release the reset condition of the variable frequency divider (2), allowing it to divide by the division ratio $n_1$,

then, the phase comparator (4) output signal is latched at the loop filter (5) by connecting the phase comparator (4) briefly to the loop filter,

then, after the variable divider (2) has completed the first cycle of division,

the variable divider (2) is set to divide by a division ratio N, and the phase detector (10) detects the phase difference between the signal from the reference oscillator (3) and the output signal from the variable divider (2) and,

if the phase detector (10) detects that the signal from the reference oscillator (3) and the output signal from the variable divider (2) differ in phase by less than a predetermined amount, the phase comparator (4) is connected to the loop filter (5) and the variable divider (2) remains set to divide by the division ratio N, and,

if the phase detector (10) detects that the signal from the reference oscillator (3) and the output signal from the variable divider (2) do not differ in phase by less than the predetermined amount, the variable frequency divider (2) is reset, again, and the operations carried out previously, from the resetting of the variable divider (2) to its being set to divide by the division ratio N, are repeated, until the phase detector (10) detects that the said phase difference is less than the predetermined amount, when the phase comparator (4) is connected to the loop filter (5) and the variable divider (2) remains set to divide by the division ratio N.

7. A frequency synthesizer as claimed in claim 6, wherein the variable divider (2) includes a division ratio data source (22) connected to a division ratio data latch circuit (26) which, in turn, is connected to a programmable counter (23), which division ratio data source (22), in operation, generates first control input data, for storage by the division ratio data latch circuit (26) and transmission to the programmable counter (23), for the generation of an output signal of frequency providing phase movement relative to the reference signal, and provides second control input data, for storage by the division ratio data latch circuit (26) and transmission to the programmable counter (23), for the generation of an output signal at the set frequency.

**Patentansprüche**

1. Ein Frequenzsynthesegerät für das Erzeugen eines Ausgangssignals, das eine Einstellfrequenz aufweist, die ein Vielfaches der Frequenz eines Referenzsignals ist und weniger als eine vorbestimmte Phasendifferenz bezüglich des Referenzsignals aufweist, wobei das Einstellfrequenzsignal mit weniger als der vorbestimmten Phasendifferenz bezüglich des Referenzsignals hergestellt wird durch Erzeugen eines Ausgangssignals der Frequenz unter Bereitstellen von Phasenbewegung relativ zu dem Referenzsignal und Beendigung der Operation bei der frequenzbereitstellenden Phasenbewegung durch Schalten auf die Einstellfrequenz, dadurch gekennzeichnet, daß im Betrieb das Frequenzsynthesegerät seinen Betrieb bei der Einstellfrequenz aufrechterhält, wenn beim Schalten auf die Einstellfrequenz die Phasendifferenz zwischen dem Einstellfrequenzsignal und dem Referenzsignal kleiner ist als die vorbestimmte Phasendifferenz, und zum Betrieb bei einer Phasenbewegung relativ zu dem Referenzsignal bereitstellender Frequenz zurückkehrt für eine weitere Periode, falls beim Schalten auf die Einstellfrequenz die Phasendifferenz zwischen dem Einstellfrequenzsignal und dem Referenzsignal nicht kleiner ist als die vorbestimmte Phasendifferenz.

2. Ein Frequenzsynthesegerät nach Anspruch 1, das während der weiteren Betriebsperiode bei einer Phasenbewegung relativ zu dem Referenzsignal bereitstellenden Frequenz bei derselben Frequenz arbeitet, die anfänglich benutzt wurde für die Bereitstellung der Phasenbewegung relativ zu dem Referenzsignal.

3. Ein Frequenzsynthesegerät nach Anspruch 1, das während der weiteren Betriebsperiode bei einer Phasenbewegung relativ zu dem Referenzsignal bereitstellenden Frequenz bei einer Frequenz arbeitet, die abweicht von jener, die anfänglich benutzt wurde für die Bereitstellung von Phasenbewegung relativ zu dem Referenzsignal.

4. Ein Frequenzsynthesegerät nach einem der Ansprüche 1 bis 3, das einen spannungsgesteuerten Oszillator (1), ein Steuersystem (2,4,5, 8,10) für den spannungsgesteuerten Oszillator (1) und Mittel (6) für das Einschalten und Ausschalten des Steuersystems (2,4,5,8,10) derart angeordnet aufweist, daß im Betrieb das Steuersystem (2,4,5,8,10) zuerst kurz eingeschaltet wird, während es eingestellt ist zum Betreiben des spannungsgesteuerten Oszillators (1) bei einer Phasenbewegung relativ zu dem Referenzsignal bereitstellenden Frequenz, wobei der spannungsgesteuerte Oszillator (1) mit Phasenbewegung relativ zu dem Referenzsignal arbeiten darf bei ausgeschaltetem Steuersystem (2,4,5,8,10), und daß der Betrieb des spannungsgesteuerten Oszillators (1) mit Phasenbewegung relativ zu dem Referenzsignal beendet wird beim erneuten Einschalten des Steuersystems (2,4,5,8,10), mit jenem System eingestellt für den Betrieb des spannungsgesteuerten Oszillators bei der Einstellfrequenz.

5. Ein Frequenzsynthesegerät nach Anspruch 4, bei dem das Steuersystem (2,4,5,8,10) ein Schleifenfilter (5) umfaßt, das im Betrieb eine Steuerspannung speichert, während das Steuersystem (2,4,5,8,10) eingeschaltet ist, und die Steuerspannung dem spannungsgesteuerten Oszillator (1) zuführt, während das Steuersystem ausgeschaltet ist, und einen Phasendetektor (10) umfaßt, der im Betrieb das Phasenverhältnis zwischen dem Ausgang des spannungsgesteuerten Oszillators (1) und dem Referenzsignal erfaßt und das Einschalten des Steuersystems (2,4,5,8,10) steuert zum Beenden des Betriebs mit Phasenbewegung relativ zu dem Referenzsignal.

6. Ein Frequenzsynthesegerät nach Anspruch 1, umfassend:
   einen spannungsgesteuerten Oszillator (1),
   einen variablen Teiler (2) mit einem Eingang, der mit dem Ausgang des spannungsgesteuerten Oszillators (1) verbunden ist, und der im Betrieb das Signal von dem spannungsgesteuerten Oszillator (1) durch einen variablen Nenner teilt,
   einen Referenzsignaloszillator (3), der eine Flanken aufweisende Ausgangswellenform aufweist,
   einen Phasenkomparator (4), der angeschlossen ist zum Empfang des Ausgangssignals des variablen Teilers (2) und des Ausgangssignals des Referenzsignaloszillators (3), und der im Betrieb diese Signale miteinander vergleicht und ein Ausgangssignal liefert, das abhängt vom Ergebnis des Vergleichs,
   ein Schleifenfilter (5), das angeschlossen ist zum Empfang des Ausgangssignals von dem Phasenkomparator (4), und das im Betrieb das Signal glättet und das geglättete Signal als Steuersignal an den spannungsgesteuerten Oszillator (1) anlegt,
   einen Phasendetektor (10), der ebenfalls angeschlossen ist zum Empfang des Ausgangssignals von dem variablen Teiler (2) und des Ausgangssignals von dem Referenzsignaloszillator (3), und der im Betrieb diese Signale miteinander vergleicht und ein Ausgangssignal liefert, das abhängt vom Ergebnis des Vergleichs, und

eine Steuerschleife (2,4,6,8) einschließlich eines Schalters (6), positioniert zum Etablieren und Wiederaufheben einer Verbindung zwischen dem Phasenkomparator (4) und dem Schleifenfilter (5), welche Steuerschleife (2,4,6,8) angeschlossen ist zum Empfang des Ausgangssignals von dem Phasendetektor (10),

wobei im Betrieb

zuerst der innere Zustand des variablen Teilers (2) rückgesetzt wird durch Einstellen desselben für das Teilen durch einen Nenner $n_1$,

dann der Phasenkomparator (4) mit dem Schleifenfilter (5) über den Schalter (6) verbunden wird,

dann eine Flanke des Ausgangs von dem Referenzsignaloszillator (3) erfaßt wird zum Lösen der Rücksetzbedingung des variablen Frequenzteilers (2), womit ihm ermöglicht wird, durch den Nenner $n_1$ zu teilen,

dann das Ausgangssignal des Phasenkomparators (4) in dem Schleifenfilter (5) zwischengespeichert wird durch kurzzeitiges Anschließen des Phasenkomparators (4) an das Schleifenfilter,

dann, nachdem der variable Teiler (2) seinen ersten Teilungszyklus vollendet hat,

der variable Teiler (2) eingestellt wird für das Dividieren durch ein Teilungsverhältnis N, und der Phasendetektor (10) die Phasendifferenz zwischen dem Signal vom dem Referenzoszillator (3) und dem Ausgangssignal von dem variablen Teiler (2) erfaßt, und,

falls der Phasendetektor (10) erfaßt, daß das Signal vom Referenzoszillator (3) und das Ausgangssignal vom variablen Teiler (2) sich in der Phase um weniger als eine vorbestimmte Größe unterscheiden, der Phasenkomparator (4) mit dem Schleifenfilter (5) verbunden wird, und der variable Teiler (2) eingestellt bleibt für die Teilung durch das Teilungsverhältnis N, und,

falls der Phasendetektor (10) erfaßt, daß das Signal vom Referenzoszillator (3) und das Ausgangssignal von dem variablen Teiler (2) sich nicht in der Phase um weniger als die vorbestimmte Größe unterscheiden, der variable Frequenzteiler (2) wieder rückgesetzt wird und die vorher ausgeführten Operationen vom Rücksetzen des variablen Teilers (2) bis zu seiner Einstellung für die Division durch das Teilungsverhältnis N wiederholt werden, bis der Phasendetektor (10) erfaßt, daß die Phasendifferenz kleiner ist als die vorbestimmte Größe, wenn der Phasenkomparator (4) mit dem Schleifenfilter (5) verbunden ist und der variable Teiler (2) eingestellt bleibt auf das Teilen durch das Teilungsverhältnis N.

7. Ein Frequenzsynthesegerät nach Anspruch 6, bei dem der variable Teiler (2) eine Teilungsverhältnisdatenquelle (22) umfaßt, angeschlossen an einen Teilungsverhältnisdaten-Zwischenspeicherschaltkreis (26), der seinerseits verbunden ist mit einem programmierbaren Zähler (23), welche Teilungsverhältnisdatenquelle (22) im Betrieb erste Steuereingangsdaten erzeugt für die Abspeicherung durch den Teilungsverhältnisdaten-Zwischenspeicherschaltkreis (26) und Übertragung zu dem programmierbaren Zähler (23) für die Erzeugung eines Ausgangssignals der Phasenbewegung relativ zu dem Referenzsignal bereitstellenden Frequenz, und zweite Steuereingangsdaten bereitstellt für die Abspeicherung durch den Teilungsverhältnisdaten-Zwischenspeicherschaltkreis (26) und übertragung zu dem programmierbaren Zähler (23) für die Erzeugung eines Ausgangssignals bei der Einstellfrequenz.

## Revendications

1. Synthétiseur de fréquence permettant de générer un signal de sortie ayant une fréquence déterminée qui est un multiple de la fréquence d'un signal de référence et possède une différence de phases par rapport au signal de référence inférieure à une valeur prédéterminée, le signal de fréquence déterminée étant établie avec une différence de phase inférieure à celle prédéterminée, par rapport au signal de référence, en générant un signal de sortie d'une fréquence fournissant un mouvement de phase par rapport au signal de référence et en terminant la mise en action à la fréquence fournissant le mouvement de phase, par connexion de la fréquence déterminée, caractérisé en ce que, en fonction le synthétiseur de fréquence maintient son action à la fréquence déterminée si, en connectant la fréquence déterminée, la différence de phase entre le signal de fréquence déterminée et le signal de référence est inférieure à la différence de phase prédéterminée, et inverse son action à une fréquence fournissant un mouvement de phase par rapport au signal de référence pendant une période supplémentaire si, en connectant la fréquence déterminée, la différence de phase entre le signal de fréquence déterminée et le signal de référence n'est pas inférieure à la différence de phase prédéterminée.

2. Synthétiseur de fréquence selon la revendication 1, qui, durant la période supplémentaire de mise en action à une fréquence fournissant un mouvement de phase par rapport au signal de référence, agit à la même fréquence que celle utilisée initialement pour fournir un mouvement de phase par rapport au signal de référence.

3.  Synthétiseur de fréquence selon la revendication 1, qui, durant la période supplémentaire de mise en action à une fréquence fournissant un mouvement de phase par rapport au signal de référence, agit à une fréquence différente de celle utilisée initialement pour fournir un mouvement de phase par rapport au signal de référence.

4.  Synthétiseur de fréquence selon l'une quelconque des revendications 1 à 3, qui inclut un oscillateur commandé en tension (1), un système de commande (2,4,5,8,10) pour l'oscillateur (1) et des moyens (6) pour connecter et déconnecter le système de commande (2,4,5,8,10) disposés de sorte que, en fonction, le système de commande (2,4,5,8,10) est tout d'abord connecté brièvement quand il est destiné à mettre en action l'oscillateur commandé en tension (1) à une fréquence fournissant un mouvement de phase par rapport au signal de référence, l'oscillateur (1) est autorisé à être mis en action avec un mouvement de phase par rapport au signal de référence, le système de commande (2,4,5,8,10) étant déconnecté, et la mise en action de l'oscillateur commandé en tension (1) avec un mouvement de phase par rapport au signal de référence est terminée en connectant à nouveau le système de commande (2,4,5,8,10) avec ce système déterminé de manière à mettre en marche l'oscillateur commandé en tension (1) à la fréquence déterminée.

5.  Synthétiseur de fréquence selon la revendication 4, dans lequel le système de commande (2,4,5,8,10) inclut un filtre de boucle (5) qui, en fonction, stocke une tension de commande alors que le système de commande (2,4,5,8,10) est connecté, et fournit la tension de commande à l'oscillateur commandé en tension (1) alors que le système de commande est déconnecté, et un détecteur de phase (10) qui, en fonction, détecte la relation de phase entre la sortie de l'oscillateur (1) et le signal de référence, et commande la connexion du système de commande (2,4,5,8,10) de manière à réaliser la mise en service avec un mouvement de phase par rapport au signal de référence.

6.  Synthétiseur de fréquence selon la revendication 1, comprenant:
    - un oscillateur commandé en tension (1),
    - un diviseur variable (2) ayant une entrée connectée avec la sortie de l'oscillateur (1) et qui, en fonction, divise le signal provenant de l'oscillateur commandé en tension (1) par un rapport de division variable,
    - un oscillateur de signal de référence (3) qui génère une sortie sous forme d'onde présentant des flancs, un comparateur de phase (4) qui est connecté de manière à recevoir le signal de sortie du diviseur variable (2) et le signal de sortie de l'oscillateur de signal de référence (3) et qui en fonction, compare ces signaux entre eux et fournit un signal de sortie dépendant du résultat de la comparaison

    - un filtre de boucle (5) qui est connecté de manière à recevoir le signal de sortie provenant du comparateur de phase (4) et qui, en fonction, lisse le signal et applique le signal lissé faisant office de signal de commande, à l'oscillateur commandé en tension (1),
    - un détecteur de phase (10) qui est également connecté de manière à recevoir le signal de sortie provenant du diviseur variable (2) et le signal de sortie provenant de l'oscillateur de signal de référence (3) et qui, en fonction, compare ces signaux entre eux et fournit un signal de sortie dépendant du résultat de la comparaison et
    - une boucle de commande (2,4,6,8) incluant un circuit de connexion (6) disposé de manière à établir et à enlever une connexion entre le comparateur de phase (4) et le filtre de boucle (5), ladite boucle de commande (2,4,6,8,) étant connectée de manière à recevoir le signal de sortie provenant du détecteur de phase (10),

dans lequel, en fonction,
tout d'abord, la condition interne du diviseur variable (2) est redéterminée en la fixant de manière à ce qu'elle divise par un rapport de division $n_1$, ensuite, le comparateur de phase (4) est connecté au filtre de boucle (5) par l'intermédiaire du circuit de connexion (6),

ensuite, un flanc de la sortie provenant de l'oscillateur de signal de référence (3) est détecté de manière à libérer la condition de remise à zéro du diviseur de fréquence variable (2), permettant à ce dernier de diviser par le rapport de division n1, le signal de sortie du comparateur de phase (4) est asservi au filtre de boucle (5) en connectant le comparateur de phase (4) brièvement au filtre de boucle,

ensuite, après que le diviseur variable (2) eut réalisé le premier cycle de division,

le diviseur variable (2) est réglé de manière à diviser selon un rapport de division N, et le détecteur de phase (10) détecte la différence de phase entre le signal provenant de l'oscillateur de référence (3) et le signal de sortie provenant du diviseur variable (2) et,

si le détecteur de phase (10) détecte que le signal provenant de l'oscillateur de référence (3) et le signal de sortie provenant du diviseur variable (2) diffèrent en phase de moins qu'une valeur prédéterminée, le comparateur de phase (4) est connecté au filtre de boucle (5) et le diviseur variable (2) demeure réglé de manière à diviser par le rapport de division N, et,

si le détecteur de phase (10) détecte que le signal provenant de l'oscillateur de référence (3) et le signal de sortie provenant du diviseur variable (2) ne diffèrent pas en phase de moins que la valeur prédéterminé, le diviseur de fréquence variable (2) est réactualisé à nouveau, et les opérations réalisées précédemment, à partir de la réactualisation du diviseur variable (2) jusqu'à ce qu'il soit réglé de manière à diviser par le rapport de division N, sont répétées, jusqu'à ce que le détecteur de phase (10) détecte que ladite différence de phase est inférieure à la valeur prédéterminée, lorsque le comparateur de phase (4) est connecté au filtre de boucle (5) et le diviseur variable (2) demeure réglé de manière à diviser par le rapport de division N.

7. Synthétiseur de fréquence selon la revendication 6, dans lequel le diviseur variable (2) inclut une source de données de rapports de division (22) connectée à un circuit d'asservissement de données de rapports de division (26) qui, à tour de rôle, est connecté à un compteur programmable (23), ladite source (22), en fonction, générant des premières données d'entrée de commande, destinées à être stockées par le circuit (26) et à être transmise au compteur programmable (23), en vue de la génération d'un signal de sortie de fréquence fournissant un mouvement de phase par rapport au signal de référence, et fournissant des secondes données d'entrée de commande, destinées à être stockées par le circuit (26) et transmises au compteur programmable (23) en vue de la génération d'un signal de sortie à la fréquence déterminée.

PRIOR ART

FIG. 1

EP 0 272 938 B1

power supply
OFF

power supply
ON

close loop

open loop

phase lock

constant VCO control voltage

intermittent operation

FIG. 2

reset

clock

programmable counter
with reset function

*21*

divided
output

division ratio
------------------

division ratio
data source

*22*

conventional variable frequency divider

FIG. 3

16

FIG. 4

reset operation of the programmable counter

FIG. 5

reference signal

reset signal

clock

divided output

delay

delay

phase error of the programmable counter

FIG. 6

preset function

FIG. 7

EP 0 272 938 B1

conventional pulse swallow type programmable counter

FIG. 8

reference signal

preset signal
(preset for 2)

clock

divided output
(1/10)

2 2 2 2 2 3 4 5 6 7 8 9 0 1 2 3 4 5 6 7 8 9 0 1 2

delay

phase locked within 1 clock
error even with delay

FIG. 9

reset signal

input clock → **programmable counter with reset function** 21

divided output

26 — **division ratio data latch circuit**

trigger

**control circuit** 27

22 — **division ratio data source**

# FIG. 10

EP 0 272 938 B1

clock

reset signal

first period | second period | third period

divided output

trigger signal for division ratio data latch circuit

n-delay division | m-division | m-division

control circuit

set "n"
send "n"
to the programmable
counter

set "m"

send "m" to the programmable
counter

preset operation

# FIG. 11

FIG. 12

FIG. 13

EP 0 272 938 B1

FIG. 14

FIG. 15

phase detector

# FIG. 16

(a)

(b)

input and output of the phase detector

# FIG. 17

28

FIG. 18

Switch Circuit

FIG. 19

frequency changing in intermittent
controlled operation (ON/OFF=1/1)

F I G. 20

F I G. 21